# EUROPEAN PATENT APPLICATION

(11) **EP 2 136 409 A1**
(43) Date of publication of application: **23.12.2009**
(21) Application number: 08158521.8
(22) Date of filing: 18.06.2008
(51) Int. Cl.: H01L 31/0232, H01L 31/052, F24J 2/06

(54) **Concentration photovoltaic cell system with light guide**

(71) Applicant: Arima EcoEnergy Technologies Corporation, Dashi Town, Taoyuan 335 (TW)
(72) Inventor: Lee, Sen-Tien, Renhe Road, Dashi Town, Taoyuan 335 (TW); Tzeng, Yen-Chang, Renhe Road, Dashi Town, Taoyuan 335 (TW); Huang, Chung-Yi, Renhe Road, Dashi Town, Taoyuan 335 (TW); HSU, Chin-Wei, Taoyuan 335 (TW)
(74) Representative: Lang, Christian

(57) **Abstract**

A concentration photovoltaic cell system with light guide includes a concentrator 10 for focusing sunlight 40; a light guide 20 located at where the sunlight 40 is focused by the concentrator 10, so that the focused light is fully coupled to an input end of the light guide 20 and propagates to an output end of the light guide 20; and a solar energy converter 30 arranged at the output end of the light guide 20 for receiving and converting the light projected from the light guide 20 into electric energy. With the above arrangements, the solar converter 30 may be located at a place not exposed to sunlight to avoid lowered energy conversion efficiency caused by temperature rising at photovoltaic cell chips 31 thereof, and the use of the light guide 20 enables increased GCR and light concentrating efficiency to enable reduced number of expensive photovoltaic cells.

## Description

### FIELD OF THE INVENTION

The present invention relates to a photovoltaic cell, and more specifically, to a concentration photovoltaic (CPV) cell system with light guide.

### BACKGROUND OF THE INVENTION

A photovoltaic cell employs the photovoltaic effect to convert solar light energy into electric energy and thereby achieving the purpose and benefits of power generation. According to the currently available techniques, the photovoltaic cell is directly exposed to sunlight for receiving and converting the solar energy into electric energy.

Generally speaking, a photovoltaic cell system must require a large amount of expensive photovoltaic material. Up to date, there is not an efficient method for utilizing photovoltaic cells to convert solar energy into electric energy. Therefore, the current unit cost (dollar per watt) of solar power generation is very expensive. To reduce the manufacturing cost of photovoltaic cell modules, external mechanisms and optical elements have been developed to reduce the usage of photovoltaic cells.

Concentration photovoltaic (CPV) cells have been used to achieve the purpose of concentrating solar energy and reducing the required amount of the expensive photovoltaic cells. The purpose is to focus the sunlight of the largest possible surface area onto the same focal point to increase the geometric concentration ratio (GCR), which translates into the reduction of the amount of photovoltaic cells required. However to ensure the proper focusing of sunlight onto the chip, a tracker is required to constantly orient the cells toward the sunlight, which also occupies additional space and is relatively heavy. When the tracker is not accurately oriented toward the sunlight, the solar energy efficiency of the CPV system is drastically reduced.

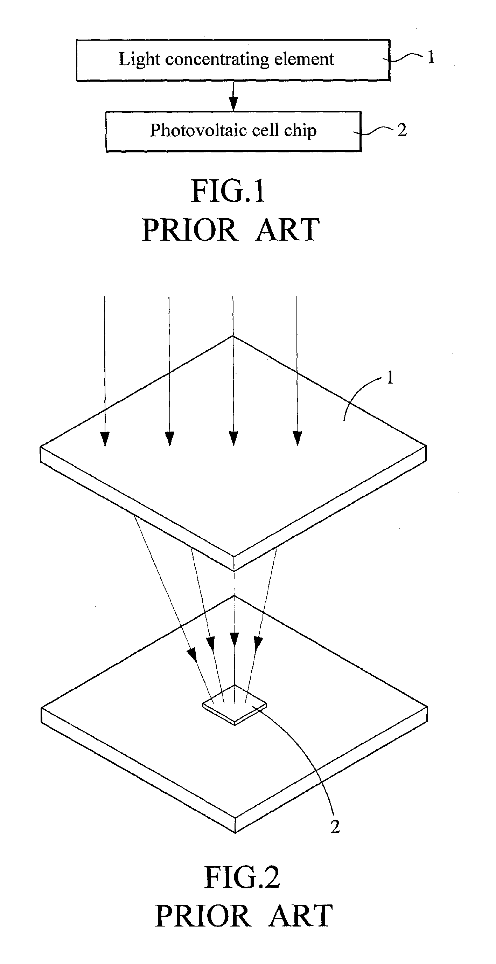

Figs. 1 and 2 illustrate a conventional concentration photovoltaic cell that includes a light concentrating element 1 for concentrating and focusing sunlight onto a photovoltaic cell chip 2. In this manner, the temperature of the chip 2 tends to increase and consequently the chip's solar conversion efficiency is adversely reduced.

### SUMMARY OF THE INVENTION

A primary object of the present invention is to provide a concentration photovoltaic cell system with light guide, in which a solar energy converter is not directly exposed to sunlight to avoid the reduced energy conversion efficiency caused by temperature rising at photovoltaic cell chips thereof.

Another object of the present invention is to provide a concentration photovoltaic cell system with light guide that has the increased GCR and light concentrating efficiency to reduce the required amount of expensive photovoltaic cells.

To achieve the above and other objects, the concentration photovoltaic cell system with light guide according to the present invention consists of a concentrator for focusing sunlight; a light guide arranged at the focal point of the concentrator, so that the focused light is fully coupled to the input end of the light guide and propagates to the output end of the light guide; and a solar energy converter arranged at the output end of the light guide for receiving and converting the light projected from the light guide into electric energy. In the present invention, the solar energy converter is a photovoltaic cell.

In the present invention, the concentrator is a light focusing lens, a reflective mirror, a thin-film concentrator, or any other optical element with equivalent light concentrating functionality.

In the present invention, the light guide consists of a light guiding medium and a lens assembly. The focused sunlight propagates through the light guiding medium to the lens assembly, and is reflected by the lens assembly onto the solar energy converter and converted into electric energy.

The light guide may further include a light splitter located at a center of the lens assembly. The light guiding medium has its output end aligned with the light splitter. When the focused light is transferred via the light guiding medium to the light splitter, the light projected onto the light splitter is reflected to the reflective mirror of the lens assembly. The light is further reflected by the reflective mirror onto the chips of the solar energy converter and converted into electric energy.

The lens assembly includes a reflective mirror and a glass plate. The output end of the light guiding medium is connected to a top of the lens assembly, and the light splitter is located at a center of the glass plate. The light splitter may be a pyramidal light splitter or a curved light splitter to reflect incident light. And, the light guiding medium may be an optical fiber cable or a light guiding plate or other functionally equivalent elements.

The light guide may further include an optical filter arranged in front of the input end of the light guiding medium for filtering out infrared light from the focused light to minimize heat contained in the focused sunlight.

The present invention provides at least the following advantages:
1. Solar energy is transferred via the light guide to another location suitable for converting into electric energy, so that the solar energy converter is not directly exposed to sunlight and thus avoids the reduction of energy conversion efficiency caused by temperature rising at the photovoltaic cell chips.
2. The use of the light guide enables the increased GCR and light concentrating efficiency and thereby reduces the amount of expensive photovoltaic cells needed in the concentration photovoltaic cell system.

### BRIEF DESCRIPTION OF THE DRAWINGS

The structure and the technical means adopted by the present invention to achieve the above and other objects can be best understood by referring to the following detailed description of the preferred embodiments and the accompanying drawings, wherein
Fig. 1 is a block diagram of a conventional concentration photovoltaic cell;
Fig. 2 is the perspective view of the conventional concentration photovoltaic cell;
Fig. 3 is a block diagram of a concentration photovoltaic cell system with light guide according to the present invention;
Fig. 4 is a general structural view of the concentration photovoltaic cell system with light guide according to the present invention;
Fig. 5 is a cross sectional view of an optical fiber cable used as a light guiding medium in a first embodiment of the contraction photovoltaic cell system of the present invention;
Fig. 6 is a structural view of a lens assembly used in the first embodiment of the present invention;
Fig. 7 is a structural view of a concentration photovoltaic cell system with light guide according to a second embodiment of the present invention, in which a light guiding plate is used as the light guiding medium;
Fig. 8 is structural view of a lens assembly used in the second embodiment of the present invention; and
Fig. 9 is a structural view of a concentration photovoltaic cell system with light guide according to a third embodiment of the present invention.

### DETAILED DESCRIPTION OF THE PREFERRED EMBODIMENTS

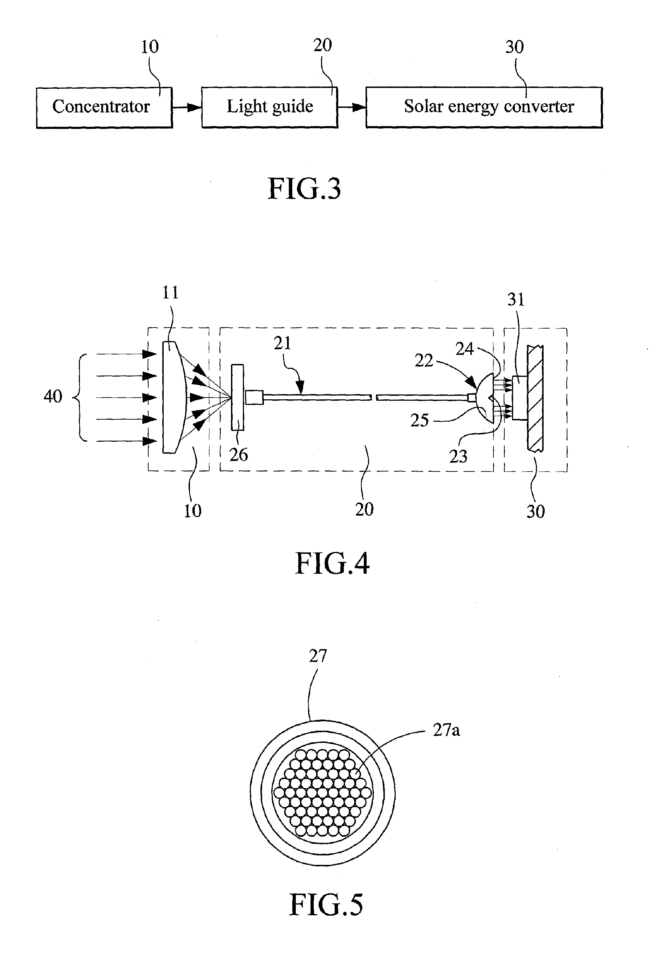

Figs. 3 and 4 show the block diagram and structural schematic of a concentration photovoltaic cell system with light guide according to the present invention, respectively. As shown, the present invention includes a concentrator 10, a light guide 20, and a solar energy converter 30.

The concentrator 10 functions to collect and focus a light source 40, such as sunlight. Alternatively, the light source 40 may be other light similar to sunlight and projected onto the concentrator 10. The concentrator 10 may be a focusing lens 11, a reflective mirror, a thin-film concentrator, or any other functionally equivalent concentrating elements. In the present invention, at least one focusing lens 11 is adopted to receive and focus sunlight.

The light guide 20 is positioned at the focal point of the concentrator 10. The focused light can be fully coupled to the input end of the light guide 20 to propagate through the light guide 20 to the output end of the light guide 20. The light guide 20 includes at least one light guiding medium 21 and at least one lens assembly 22 connected to the light guiding medium 21. The lens assembly 22 consists of a reflective mirror 25 and a glass plate 24. The output end of the light guiding medium 21 is extended to the inner side of the reflective mirror 25 of the lens assembly 22 and aligned with a center of the glass plate 24. When the light propagates through the light guiding medium 21 to the lens assembly 22, the light projects on and is reflected by the reflective mirror 25 onto at least one photovoltaic cell chip 31 of the solar energy converter 30, and converted into electric energy.

The light guide 20 may further include at least one light splitter 23, and the output end of the light guiding medium 21 is aligned with the light splitter 23. When the focused light projects from the output end of the light guiding medium 21 onto the reflective mirror 25 and is then reflected by the reflective mirror 25 onto the chip 31 of the solar energy converter 30, the light is converted into electric energy. The light splitter 23 may be a pyramidal or a curved light splitting medium.

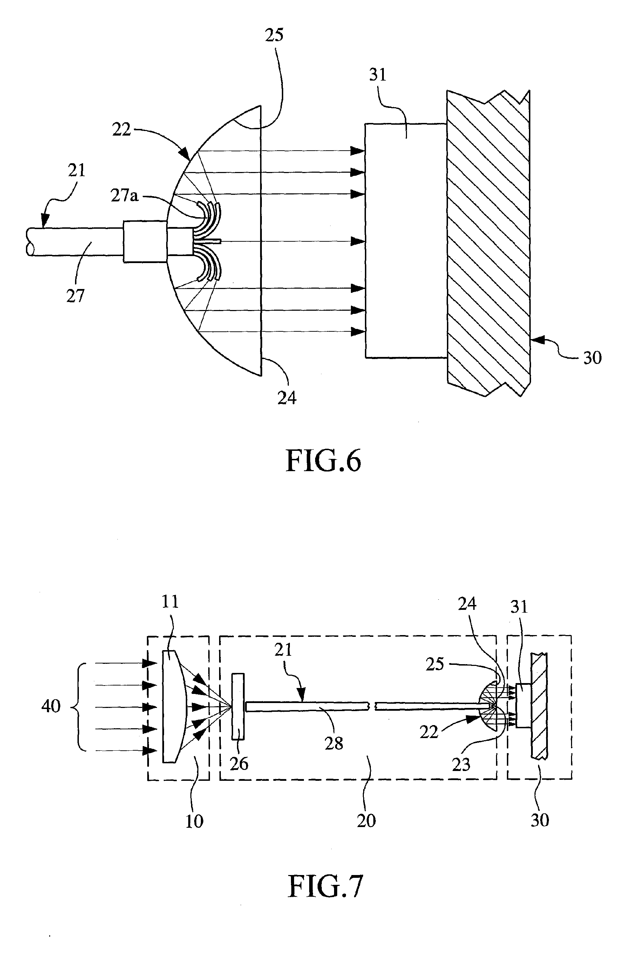

The light guiding medium 21 may be an optical fiber cable 27 as shown in Fig. 6, or a light guiding plate 28 as shown in Fig. 7, or any other functionally equivalent light guiding media. To minimize the heat contained in the light source when the latter enters the solar energy converter 30, an optical filter 26 is arranged in front of the input end of the light guiding medium 21 for filtering out infrared light from the focused light to reduce the heat contained in the focused light.

The solar energy converter 30 is arranged at the output end of the light guide 20 for receiving the light projected from the light guide 20 and converting the received light into electric energy. In the present invention, the solar energy converter 30 is a concentration photovoltaic cell.

Fig. 5 is a cross sectional view of the optical fiber cable 27 adopted in a first embodiment of the contraction photovoltaic cell system of the present invention, and Fig. 6 shows the lens assembly 22 used with the optical fiber cable 27. As can be seen from Fig. 5, the optical fiber cable 27 may contain one single optical fiber 27a for the usage with a photovoltaic cell having a relatively small area, or a plurality of optical fibers 27a for the usage with a photovoltaic cell having a relatively large area, depending on actual need in design. As shown in Fig. 6, when the focused light propagates through the light guide 20 to the lens assembly 22, the light projects from the optical fibers 27a of the optical fiber cable 27 to the reflective mirror 25, and is then reflected by the reflective mirror 25 onto the photovoltaic cell chip 31 of the solar energy converter 30, and converted into electric energy.

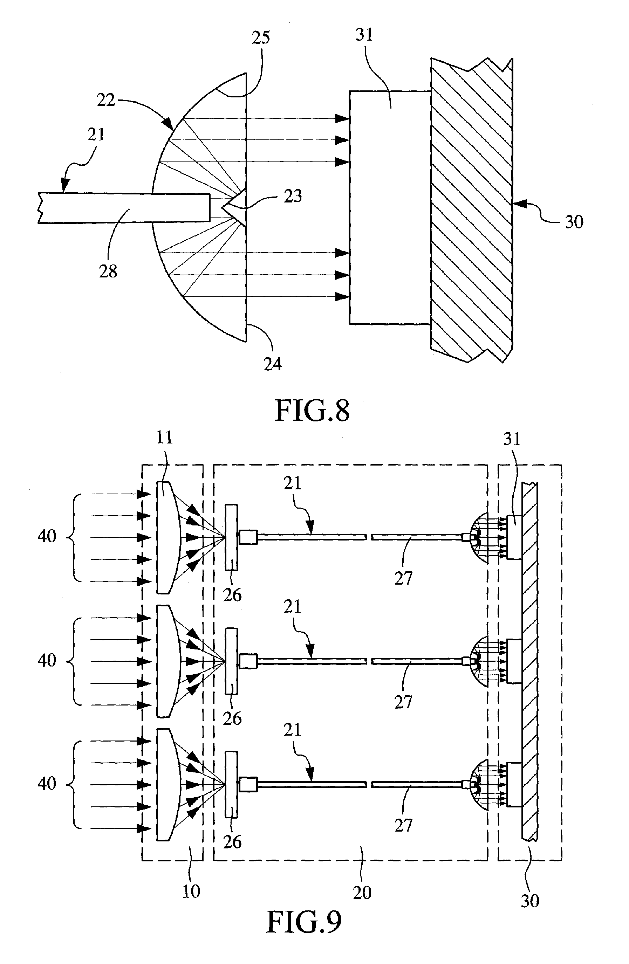

Fig. 7 shows the concentration photovoltaic cell system according to a second embodiment of the present invention, in which a light guiding plate 28 is adopted as the light guiding medium 21, and Fig. 8 shows the lens assembly 22 used with the light guiding plate 28. The light guiding plate 28 may have a variable thickness according to the actual design need. The light guiding plate 28 is aligned with the light splitter 23. When the focused light propagates through the light guiding plate 28 to the lens assembly 22, the light projects from the light guiding plate 28 to the pyramidal light splitter 23, and is reflected onto the reflective mirror 25 before being further reflected by the reflective mirror 25 to the photovoltaic cell chip 31 of solar energy converter 30 and converted into electric energy.

Alternatively, the pyramidal light splitter 23 may be replaced with a curved light splitter (not shown) to provide the same light reflecting effect.

Fig. 9 shows a concentration photovoltaic cell system with light guide according to a third embodiment of the present invention. In the third embodiment, there is a plurality of light focusing lens 11 provided in the concentrator 10 corresponding to a plurality of light guiding media 21 in the light guide 20 and a plurality of photovoltaic cell chips 31 in the solar energy converter 30. These light focusing lens 11, light guiding media 21, and photovoltaic cell chips 31 have the same configuration, size, and structure as those shown in Figs. 3 to 8. Similarly, the light guiding media 21 may be optical fiber cables 27 or light guiding plates 28. In the illustrated Fig. 9, the light guiding media 21 are optical fiber cables 27. In the illustrated third embodiment, there are three light focusing lens 11 separately concentrating and focusing three light sources 40, and three light guiding media 21 separately arranged at positions at where the three light sources 40 are focused by the three light focusing lens 11, and the focused light is fully coupled to the input ends of the three optical fiber cables 27 to propagate to output ends of the optical fiber cables 27. Meanwhile, there are three photovoltaic cell chips provided at the solar energy converter 30 corresponding to the output ends of the three optical fiber cables 27 to receive and convert the light projected from the optical fiber cables 27 into electric energy.

The concentration photovoltaic cell system with light guide according to the present invention provides at least the follow advantages:
1. Light energy is transferred via the light guide to another location suitable for converting into electric energy, so that the solar energy converter is not directly exposed to sunlight and avoids the reduction of energy conversion efficiency caused by temperature rising at the photovoltaic cell chip thereof.
2. The use of the light guide enables the increased GCR and light concentrating efficiency and thereby enables the reduction of the amount of expensive photovoltaic cells in the concentration photovoltaic cell system.

The present invention has been described with some preferred embodiments thereof and it is understood that many changes and modifications in the described embodiments can be carried out without departing from the scope and the spirit of the invention that is intended to be limited only by the appended claims.

## Claims

1. A concentration photovoltaic cell system with light guide, comprising:
a concentrator 10 for concentrating and focusing a light source 40;
a light guide 20 arranged at the focal point of the concentrator 10; the light guide 20 including an input end and an output end, and the focused light source 40 being coupled to the input end of the light guide 20 to propagate through the light guide 20 to the output end thereof; and
a solar energy converter 30 arranged at the output end of the light guide 20 for receiving the light projected from the output end of the light guide 20 and converting the received light into electric energy.

2. The concentration photovoltaic cell system with light guide as claimed in claim 1, wherein the solar energy converter 30 is a photovoltaic cell.

3. The concentration photovoltaic cell system with light guide as claimed in claim 1, wherein the concentrator 10 is a light focusing lens 11.

4. The concentration photovoltaic cell system with light guide as claimed in claim 1, wherein the concentrator 10 is a reflective mirror.

5. The concentration photovoltaic cell system with light guide as claimed in claim 1, wherein the concentrator 10 is a thin-film concentrator.

6. The concentration photovoltaic cell system with light guide as claimed in claim 1, wherein the light guide 20 includes at least one light guiding medium 21 and at least one lens assembly 22 connected to an output end of the light guiding medium 21; and the focused light propagates through the light guiding medium 21 to the lens assembly 22 and is reflected by the lens assembly 22 onto the solar energy converter 30.

7. The concentration photovoltaic cell system with light guide as claimed in claim 6, wherein the light guide 20 further includes at least one light splitter 23, and the output end of the light guiding media 21 is aligned with the light splitter 23.

8. The concentration photovoltaic cell system with light guide as claimed in claim 6, wherein the lens assembly 22 includes a reflective mirror 25 and a glass plate 24, and the output end of the light guiding media 21 is connected to the reflective mirror 25.

9. The concentration photovoltaic cell system with light guide as claimed in claim 7, wherein the light splitter 23 is a pyramidal light splitter.

10. The concentration photovoltaic cell system with light guide as claimed in claim 7, wherein the light splitter 23 is a curved light splitter.

11. The concentration photovoltaic cell system with light guide as claimed in claim 6, wherein the light guiding medium 21 is an optical fiber cable 27.

12. The concentration photovoltaic cell system with light guide as claimed in claim 6, wherein the light guiding medium 21 is a light guiding plate 28.

13. The concentration photovoltaic cell system with light guide as claimed in claim 6, wherein the light guide 20 further includes an optical filter 26 arranged in front of an input end of at least one light guiding medium 21 for filtering out infrared light from the focused light to minimize heat contained in the focused light.
